(19) Europäisches Patentamt
European Patent Office
Office européen des brevets

(11) **EP 2 381 473 B1**

(12) **EUROPÄISCHE PATENTSCHRIFT**

(45) Veröffentlichungstag und Bekanntmachung des Hinweises auf die Patenterteilung:
**03.10.2018 Patentblatt 2018/40**

(51) Int Cl.:
*H01L 23/051* *(2006.01)*   *H01L 29/861* *(2006.01)*
*H01L 29/06* *(2006.01)*   *H01L 29/16* *(2006.01)*
*H01L 29/20* *(2006.01)*

(21) Anmeldenummer: **11156124.7**

(22) Anmeldetag: **28.02.2011**

(54) **Temperaturwechselfeste Einpressdiode**

Press-fit diode resistant to changes in temperature

Diode à montage compressé résistante aux changements de température

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **26.04.2010 DE 102010028196**

(43) Veröffentlichungstag der Anmeldung:
**26.10.2011 Patentblatt 2011/43**

(73) Patentinhaber:
• **Robert Bosch GmbH**
**70442 Stuttgart (DE)**
• **SEG Automotive Germany GmbH**
**70499 Stuttgart (DE)**

(72) Erfinder:
• **Spitz, Richard**
**72766 Reutlingen (DE)**
• **Jaros, Rolf**
**71522 Backnang (DE)**
• **Goerlach, Alfred**
**72127 Kusterdingen (DE)**
• **Suelzle, Helmut**
**71691 Freiberg (DE)**

(56) Entgegenhaltungen:
EP-A2- 2 075 835   US-A- 5 908 316
US-A1- 2005 218 425   US-A1- 2006 246 642
US-A1- 2007 228 505   US-B1- 6 362 495

**Beschreibung**

Die Erfindung betrifft eine Einpressdiode mit einer temperaturwechselfesten Lotverbindung. Eine derartige Diode eignet sich insbesondere als Diode für den Einsatz in Kfz-Generatorsystemen.

Stand der Technik

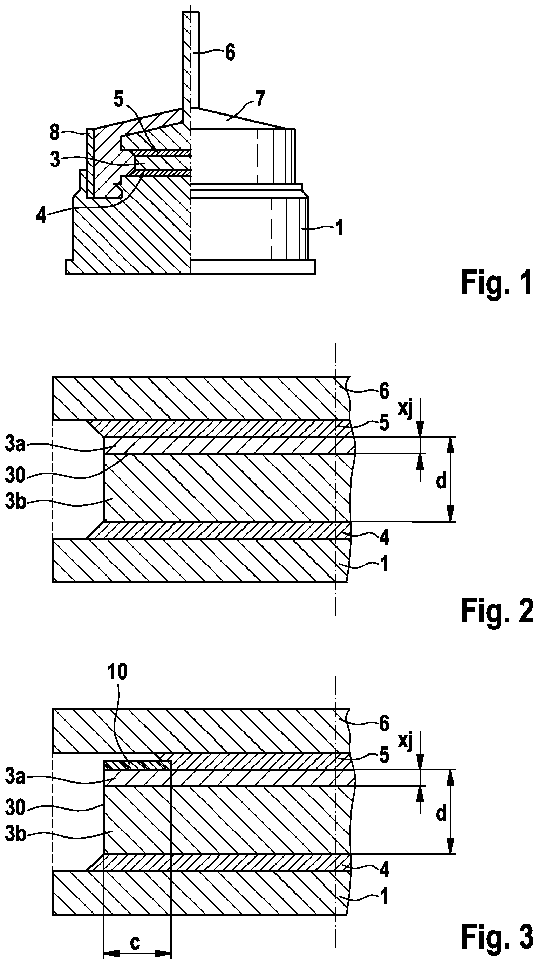

In Kfz-Generatorsystemen werden zur Gleichrichtung des Wechsel- bzw. Drehstroms meist PN-Dioden aus Silizium eingesetzt. In der Regel werden diese Dioden in spezielle Gehäuse - sogenannte Einpressgehäuse - montiert, wie es aus der Figur 1 ersichtlich ist. Die Einpressdioden weisen dabei einen mit einer Rändelung versehenen Einpresssockel 1 auf, der in eine entsprechende Aussparung einer Gleichrichteranordnung eingepresst ist. Der Einpresssockel übernimmt dabei gleichzeitig eine dauerhafte thermische und elektrische Verbindung der Gleichrichterdiode mit der Gleichrichteranordnung. Der Einpresssockel weist einen Befestigungsbereich auf, an dem ein Halbleiterchip 3 beispielsweise durch ein Lot 4 befestigt ist. Dabei ist die Ober- und Unterseite des Halbleiterchips 3 vollständig mit einer dünnen, in der Abbildung nicht eingezeichneten Metallisierung versehen. Die Metallisierung besteht beispielsweise aus einer Schichtenfolge von unterschiedlichen Metallen. Beispielsweise kann eine Schichtenfolge aus Cr, NiV7 und Ag Verwendung finden. Auf dem Halbleiterchip 3 wiederum ist ebenfalls beispielsweise durch ein Lot 5 ein sogenannter Kopfdraht 6 befestigt, der elektrisch durch Löten oder Schweißen oder einer sonstigen Befestigungstechnik fest mit anderen Komponenten des Gleichrichters kontaktiert ist. Der zwischen die beiden Kupferteile gelötete Siliziumchip 3 ist mit einer isolierenden Kunststoffmasse 7 umhüllt. Als Kunststoffmasse kann zum Beispiel ein mit Quarzkörnern gefülltes Epoxid oder ein sonstiger hoch temperaturfester Kunststoff dienen. Zur Einbringung der Kunststoffmasse 7 wird meist ein zusätzlicher Kunststoffring 8 angebracht. Oftmals befindet sich noch eine in Fig. 1 nicht gezeichnete zusätzliche, weiche Kunststoffschicht zwischen dem Chip 3 und dem Epoxid 7. Die Kupferteile 4, 5 sind ggf. mit einer dünnen Oberflächenschicht aus Nickel versehen.

Bei einem Betrieb der Diode in Durchlassrichtung fällt an ihr eine Flussspannung UF ab, die sich bei Raumtemperatur und Stromdichten von $500A/cm^2$ etwa auf einen Wert von 1V einstellt. Der damit verbundene Leistungsabfall wird in Wärme umgewandelt und über das Einpressdiodengehäuse und den Gleichrichter des Generators abgeführt. Dadurch steigt die Sperrschichttemperatur Tj der Diode an. So werden bei hohen Generatorströmen und zusätzlich hohen Umgebungstemperaturen an der Diode Sperrschichttemperaturen Tj bis zu 240°C gemessen. In der Praxis werden die Dioden eines Kfz-Generators vielen Temperaturzyklen ausgesetzt. Beispielsweise sollen 3000 Temperaturzyklen mit einer Ausfallrate unter 1% überstanden werden. Verschärft wird die Situation durch vermehrten Einsatz von modernen Start-Stopp- bzw. Rekuperationssystemen, bei denen etwa 0,2- 2 Millionen Temperaturzyklen von etwa 40°C bis 80°C, die der mittleren Diodentemperatur überlagert sind, zusätzlich auftreten können.

Bei den hohen Temperaturen darf das verwendete Lot 4,5 nicht aufschmelzen. Deshalb - sowie aus Gründen eines minimalen Lotverschleißes - wird ein Lot verwendet, dessen Schmelztemperatur Ts möglichst weit oberhalb der maximal auftretenden Sperrschichttemperatur Tj liegt. So werden bis heute in der Regel hoch bleihaltige Lote verwendet, deren Solidustemperatur Ts über 300°C liegt.

Die in der Diode zusammengefügten Stoffe Silizium, bleihaltiges Lot und Kupfer weisen große Unterschiede in den physikalischen Materialeigenschaften auf. So sind beispielsweise Ausdehnungskoeffizienten und Elastizitätsmodule sehr unterschiedlich. Bei Temperaturwechseln treten deshalb hohe mechanische Spannungen auf. Die während den Temperaturhüben in den Bleiloten auftretende mechanische Spannung erreicht und übersteigt dabei schnell die Elastizitätsgrenze des Lots. Dies hat zur Folge, dass das Lot beginnt sich plastisch zu verformen. Dabei kommt es zu einem Vorgang, der als Lotkriechen bezeichnet wird. Im Fall der Einpressdiode quillt das Lot dabei im Laufe der Zeit aus seiner ursprünglichen Position heraus und kriecht entlang der Kupfer- bzw. Chipseiten weiter. Grundsätzlich tritt der beschriebene Effekt auch bei bleifreien Weichloten auf.

In Fig. 2 ist eine vergrößerte Darstellung eines Teils der in der Figur 1 gezeigten Einpressdiode im Querschnitt dargestellt. Die Bezeichnungen sind weitgehend mit denen in Fig. 1 identisch. Der Halbleiterchip 3 ist in eine Zone 3a und eine Zone 3b mit unterschiedlichen Leitfähigkeitstypen, die durch einen PN-Übergang getrennt sind, aufgeteilt. Der PN-Übergang befindet sich in einer Eindringtiefe xj unterhalb der Chipoberseite. Die gesamte Chipdicke ist mit d bezeichnet. Die Zone 3a kann beispielsweise aus p-dotiertem und die Zone 3b aus n-dotiertem Silizium bestehen. Natürlich kann auch eine umgekehrte Schichtenfolge gewählt werden. Wesentlich ist, dass der PN-Übergang 30 bis zur Chipkante reicht, d. h. an der Chipkante austritt.

Tritt nun während des Betriebs mit Temperaturwechselbelastung Lotkriechen auf, kann das Lot entlang der Chipkanten kriechen. Insbesondere für den Fall, dass die Eindringtiefe xj klein ist, kann das Lot 5 leicht die Zone 3a überbrücken. Wenn das Lot 5 über die Zone 3a am Chiprand über den PN-Übergang 30 bis zum Bereich 3b wandert, ist die Diode kurzgeschlossen.

Aus der US 5,908,316 A und der EP 2 075 835 A2 sind bereits Dioden bekannt, die mit Kühl- und Kontaktierungskörpern verbunden sind.

Offenbarung der Erfindung

Eine Einpressdiode mit den im Anspruch 1 angegebenen Merkmalen weist demgegenüber den Vorteil auf, dass der Kriechweg des Lotes verlängert ist und dadurch ein durch Lotkriechen hervorgerufener Kurzschluss hinausgezögert ist. Dadurch ist die Temperaturwechselfestigkeit einer Einpressdiode erhöht bzw. bei gleicher Temperaturwechselfestigkeit die maximal zulässige Chiptemperatur Tj erhöht. Ein weiterer Vorteil besteht darin, dass die Möglichkeit bereitgestellt wird, Halbleiterdioden mit sehr flachen PN-Übergängen in Einpressdiodengehäusen zu verpacken. Beispielsweise können statt der bisher üblichen Eindringtiefen von 30 $\mu$m - 60 $\mu$m auch Dioden mit Eindringtiefen im Bereich von 1$\mu$m oder darunter in Einpressdiodengehäusen montiert werden. Diese Vorteile werden dadurch erreicht, dass bei einer Einpressdiode, die einen durch Weichlot zwischen einem Sockel und einem Kopfdraht befestigten Halbleiterchip aufweist, bei dem mindestens ein PN-Übergang am Chipaußenrand endet, das Weichlot in dem Außenbereich, der den kleinsten Abstand vom PN-Übergang hat, relativ zum Chipaußenrand umlaufend zurückgezogen ist.

Vorteilhafte Ausgestaltungen und Weiterbildungen der Erfindung sind in den abhängigen Ansprüchen angegeben.

Nachfolgend wird die Erfindung anhand der Figuren 3 - 5 beispielhaft erläutert.

Ein erstes Ausführungsbeispiel für eine Einpressdiode gemäß der Erfindung ist in der Figur 3 veranschaulicht, in welcher eine vergrößerte Darstellung eines Teils einer Einpressdiode gemäß der Erfindung gezeigt ist. Im Gegensatz zu der bekannten Einpressdiode ist die Lotschicht 5, die sich in der Nähe des PN-Übergangs 30 befindet, um den Abstand C von der Chipkante zurückgezogen. Dies ist dadurch erreicht, dass sich zwischen Lot und Chipkante eine vollständig umlaufende, elektrisch isolierende dielektrische Schicht 10 befindet. Da das Weichlot 5 sich nur mit den Stellen des Chips verbindet, die aus der nicht eingezeichneten Chipmetallisierung bestehen, bildet sich eine Lotschicht auch nur an den Stellen aus, die nicht von der isolierenden Schicht 10 bedeckt sind. Die nicht eingezeichnete, lötfähige Chipmetallisierung besteht zum Beispiel aus einer dünnen Schichtenfolge von 70nm Cr, 300nm NiV7 und 250nm Ag. Natürlich können auch andere Schichtenfolgen Verwendung finden. Beispielsweise kann sich unter dem NiV eine dickere Aluminiumschicht befinden. Als isolierende Schichten können in der Halbleitertechnik übliche Materialien wie thermische Oxide, Low Temperature Oxides (LTO), dotierte Siliziumgläser wie BSPG, Siliziumnitridschichten usw., eingesetzt werden. Besonders vorteilhaft können auch Schichtenfolgen verwendet werden. So kann die Schicht beispielsweise aus 0,6 $\mu$m LTO + 1 $\mu$m Siliziumnitrid bestehen.

Der Abstand C, der im Wesentlichen durch die Breite der isolierenden Schicht 10 definiert ist, ist dabei so gewählt, dass der Kriechweg des Lotes bis zum PN-Übergang 30 sowohl von Lot 5 als auch von Lot 4 etwa identisch ist. Es gilt:

$$C \geq d - 2 * x_j \qquad\qquad (F1)$$

In Fig. 3 befindet sich die Lotschicht 5 in Kontakt mit dem Kopfdraht 6, die Lotschicht 4 in Kontakt mit dem Sockel 1. Selbstverständlich können die Seiten auch vertauscht werden, so dass die zurückgezogene Lotschicht 5 mit dem Sockel 1 in Berührung kommt.

Das Ausführungsbeispiel gemäß Fig. 3 enthält einen Halbleiterchip, dessen PN-Übergang 30 eine konstante Tiefe $x_j$ aufweist. Häufig werden aber auch Diodenchips verwendet, bei denen die Schichten 3a und 3b am Chiprand eine andere Dotierung und eine andere Eindringtiefe aufweisen.

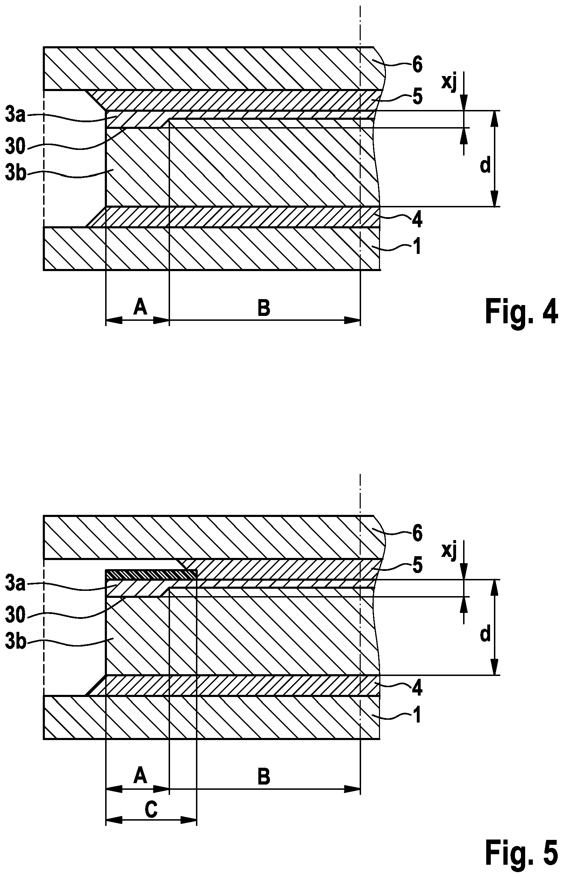

Dies ist in der Fig. 4 veranschaulicht. Beispielsweise ist die Eindringtiefe $x_j$ am Chiprand in einem Bereich A größer als im inneren Bereich B des Chips. Dadurch kann beispielsweise erreicht werden, dass ein schmaler, umlaufender Randbereich A eine höhere Durchbruchsspannung als der größere, innere Bereich B zeigt. Als Eindringtiefe $x_j$ wird jetzt die Tiefe des PN-Übergangs 30 am Chiprand bezeichnet. Grundsätzlich können sich in den Bereichen A und B sogar vollständig unterschiedliche Dioden befinden. Beispielsweise kann sich im Bereich A eine PN-Diode und im Bereich B eine Schottkydiode, Trench-Barrrier-Schottkydiode oder ähnliches befinden.

Auch in diesem Fall besteht die Gefahr von Kurzschlüssen des PN-Überganges durch Lotkriechen. Ein weiteres erfindungsgemäßes Ausführungsbeispiel ist deshalb in Fig. 5 dargestellt. Bezeichnungen und Schichten sind analog zum ersten Ausführungsbeispiel gemäß Fig. 3 gewählt. In Fig. 5 wird der Bereich der isolierenden Schicht C größer als die Weite A gewählt. Grundsätzlich kann er aber auch kleiner als A sein. Für die Auslegung der Weite C gilt wiederum die mit F1 bezeichnete Beziehung aus dem ersten Beispiel. Wiederum können Ober- und Unterseite des Chips vertauscht sein.

Einpressdioden gemäß der Erfindung können insbesondere als Gleichrichterdioden in Wechselstromgeneratoren, als besonders temperaturwechselfeste Gleichrichterdioden in Wechselstromgeneratoren mit Rekuperationsbetrieb oder als besonders temperaturwechselfeste Bypass-Dioden in Solarmodulen Verwendung finden.

**Patentansprüche**

1. Einpressdiode, die einen durch Weichlot zwischen einem Sockel und einem Kopfdraht befestigten Halbleiterchip aufweist, bei dem mindestens ein PN-Übergang am Chipaußenrand endet, **dadurch gekennzeichnet, dass** das Weichlot (5) auf einer ersten Seite in dem Außenbereich, der den kleinsten Abstand vom PN-Übergang (30) hat, relativ zum Chipaußenrand umlaufend zurückgezogen ist, indem sich über dem lotfreien Bereich des Halbleiterchips eine umlaufende, isolierende Schicht (10) befindet und dass eine zweite Seite des Halbleiterchips vollständig mit Weichlot (4) versehen ist.

2. Einpressdiode nach Anspruch 1 oder 2, **dadurch gekennzeichnet, dass** die Eindringtiefe (xj) des PN-Überganges in einem Bereich (A) am Chiprand größer als die Eindringtiefe im Inneren des Halbleiterchips ist.

3. Einpressdiode nach einem der vorhergehenden Ansprüche, **dadurch gekennzeichnet, dass** sich im Bereich (A) am Chiprand ein PN-Übergang mit der Eindringtiefe (xj) und im Inneren des Halbleiters eine Schottkydiode befindet.

4. Einpressdiode nach einem der vorhergehenden Ansprüche, **dadurch gekennzeichnet, dass** sie als isolierende Schicht eine Kombination aus Oxiden und Siliziumnitrid aufweist.

5. Einpressdiode nach einem der vorhergehenden Ansprüche, **dadurch gekennzeichnet dass** folgendes gilt:

$$C \geq d - 2^* \, x_j,$$

wobei C die Breite des zurückgezogenen Bereichs, xj die Eindringtiefe und d die Chipdicke ist.

6. Einpressdiode nach einem der vorhergehenden Ansprüche, **dadurch gekennzeichnet, dass** als Halbleitermaterial ein Wide Band Gap Halbleiter verwendet wird, vorzugsweise SiC oder GaN.

7. Einpressdiode nach einem der Ansprüche 3 - 5, **dadurch gekennzeichnet, dass** als Schottkydiode eine Trench-MOS-Barrier-Schottky-Diode (TMBS) verwendet ist.

8. Einpressdiode nach einem der Ansprüche 3 - 5, **dadurch gekennzeichnet, dass** als Schottkydiode eine Trench-Junction-Barrier-Schottky-Diode (TJBS) verwendet ist.

**Claims**

1. Press-fit diode comprising a semiconductor chip which is secured by soft solder between a base and a head wire and in which at least one PN junction ends at the chip outer edge, **characterized in that** the soft solder (5) is drawn back circumferentially relative to the chip outer edge on a first side in the outer region that is at the smallest distance from the PN junction (30) by virtue of the fact that a circumferential, insulating layer (10) is situated above the solder-free region of the semiconductor chip, and **in that** a second side of the semiconductor chip is completely provided with soft solder (4).

2. Press-fit diode according to Claim 1 or 2, **characterized in that** the penetration depth (xi) of the PN junction in a region (A) at the chip edge is greater than the penetration depth in the interior of the semiconductor chip.

3. Press-fit diode according to either of the preceding claims, **characterized in that** a PN junction having the penetration depth (xj) is situated in the region (A) at the chip edge and a Schottky diode is situated in the interior of the semiconductor.

4. Press-fit diode according to any of the preceding claims, **characterized in that** it comprises a combination of oxides and silicon nitride as insulating layer.

5. Press-fit diode according to any of the preceding claims, **characterized in that** the following holds true:

$$C \geq d - 2* \; xj$$

where C is the width of the drawn-back region, xj is the penetration depth, and d is the chip thickness.

6. Press-fit diode according to any of the preceding claims, **characterized in that** a wide band gap semiconductor is used as semiconductor material, preferably SiC or GaN.

7. Press-fit diode according to any of Claims 3 - 5, **characterized in that** a trench MOS barrier Schottky diode (TMBS) is used as Schottky diode.

8. Press-fit diode according to any of Claims 3 - 5, **characterized in that** a trench junction barrier Schottky diode (TJBS) is used as Schottky diode.

**Revendications**

1. Diode à insérer, laquelle possède une puce en semiconducteur qui est fixée par brasage tendre entre un socle et un fil de tête et avec laquelle au moins une transition PN se termine au niveau du bord extérieur de puce, **caractérisée en ce que** la brasure tendre (5), sur un premier côté dans la zone extérieure qui présente le plus petit écart par rapport à la transition PN (30), est en retrait sur la périphérie par rapport au bord extérieur de puce du fait qu'une couche isolante (10) périphérique se trouve au-dessus de la zone sans brasure de la puce en semiconducteur, et **en ce qu'**un deuxième côté de la puce en semiconducteur est entièrement pourvu de brasure tendre (4) .

2. Diode à insérer selon la revendication 1 ou 2, **caractérisée en ce que** la profondeur de pénétration (xj) de la transition PN dans une zone (A) au niveau du bord de la puce est plus grande que la profondeur de pénétration à l'intérieur de la puce en semiconducteur.

3. Diode à insérer selon l'une des revendications précédentes, **caractérisée en ce qu'**une transition PN ayant la profondeur de pénétration (xj) se trouve dans la zone (A) au niveau du bord de la puce et une diode Schottky se trouve à l'intérieur de la puce en semiconducteur.

4. Diode à insérer selon l'une des revendications précédentes, **caractérisée en ce qu'**elle possède comme couche isolante une combinaison d'oxydes et de nitrure de silicium.

5. Diode à insérer selon l'une des revendications précédentes, **caractérisée en ce que** l'équation suivante s'applique :

$$C \geq d - 2*xj,$$

où C désigne la largeur de la zone en retrait, xj la profondeur de pénétration et d l'épaisseur de la puce.

6. Diode à insérer selon l'une des revendications précédentes, **caractérisée en ce que** le matériau semiconducteur utilisé est un semiconducteur à large écart énergétique, de préférence du SiC ou du GaN.

7. Diode à insérer selon l'une des revendications 3 à 5, **caractérisée en ce que** la diode Schottky utilisée est une diode Schottky à barrière MOS de tranchée (TMBS).

8. Diode à insérer selon l'une des revendications 3 à 5, **caractérisée en ce que** la diode Schottky utilisée est une diode Schottky à barrière de jonction de tranchée (TJBS).

Fig. 1

Fig. 2

Fig. 3

**Fig. 4**

**Fig. 5**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5908316 A
- EP 2075835 A2